## Europäisches Patentamt

## European Patent Office

## Office européen des brevets

(19)

(11) Numéro de publication : **0 078 731**
**B1**

(12) **FASCICULE DE BREVET EUROPÉEN**

(45) Date de publication du fascicule du brevet :
**02.03.88**

(51) Int. Cl.⁴ : **G 01 R 33/032, G 02 F 1/09**

(21) Numéro de dépôt : **82401949.1**

(22) Date de dépôt : **22.10.82**

(54) **Dispositif interférométrique de mesure de champ magnétique, et capteur de courant électrique comportant un tel dispositif.**

(30) Priorité : **03.11.81 FR 8120594**

(43) Date de publication de la demande :
**11.05.83 Bulletin 83/19**

(45) Mention de la délivrance du brevet :
**02.03.88 Bulletin 88/09**

(84) Etats contractants désignés :
**DE GB NL SE**

(56) Documents cités :
**CH-A- 512 076**
**US-A- 3 756 690**
**OPTICAL AND QUANTUM ELECTRONICS, vol. 7, no. 6, 1975, pages 493-504, Londres, G.B.; M. GAMA:"System design considerations for precision measurement of high magnetic fields by Faraday effect"**
**ELECTRONICS LETTERS, vol. 17, no. 17, 1981, pages 596,597, Londres, G.B.; J.J. ROSS:"Measurement of magnetic field by polarisation optical timedomain reflectometry"**
**OPTICS COMMUNICATIONS, vol. 12, no. 4, 1974, pages 414,415, Amsterdam, NL; LECLERT et al.:"Propagation et modulation de la lumière à 1.064mu dans les grenats magnétiques"**
**IEEE TRANSACTIONS ON INSTRUMENTATION AND MEASUREMENT, vol. 25, no. 1, mars 1976, pages 1-7, New York, USA; THOMPSON et al.:"Optical measurement of high electric and magnetic fields"**

(73) Titulaire : **THOMSON-CSF**
**173, Boulevard Haussmann**
**F-75379 Paris Cedex 08 (FR)**

(72) Inventeur : **Papuchon, Michel**
**THOMSON-CSF SCPI 173, bld Haussmann**
**F-75379 Paris Cedex 08 (FR)**
Inventeur : **Arditty, Hervé**
**THOMSON-CSF SCPI 173, bld Haussmann**
**F-75379 Paris Cedex 08 (FR)**
Inventeur : **Puech, Claude**
**THOMSON-CSF SCPI 173, bld Haussmann**
**F-75379 Paris Cedex 08 (FR)**

(74) Mandataire : **Lepercque, Jean et al**
**THOMSON-CSF SCPI 19, avenue de Messine**
**F-75008 Paris (FR)**

## Description

L'invention concerne un capteur de champ magnétique insensible aux paramètres extérieurs tels que la température et la pression par exemple.

Dans un interféromètre en anneau, deux faisceaux parcourent en sens opposés un même trajet optique, et interfèrent à la sortie de ce trajet. Pour autant qu'une perturbation de ce trajet présente les mêmes caractéristiques pour les deux sens de propagation et ne varie pas pendant la durée du transit de la lumière dans l'interféromètre, les deux faisceaux sont affectés identiquement et leur phase relative demeure inchangée. Les perturbations de ce type sont dites « réciproques ». Parce que le temps de transit dans un interféromètre est généralement très petit, les variations d'une perturbation pendant ce temps, sauf si celle-ci est introduite volontairement, sont généralement négligeables.

Mais il existe des perturbations « non réciproques » qui présentent une amplitude différente aux deux sens de propagation, il s'agit d'effets physiques qui, en établissant son orientation complète, détruisent la symétrie de l'espace ou du milieu.

Deux effets connus présentent cette propriété :
— l'effet Sagnac, ou effet inertiel relativiste, où la rotation de l'interféromètre par rapport à un repère galliléen détruit la symétrie des temps de propagation ;
— l'effet Faraday, ou effet magnéto-optique colinéaire, où un champ magnétique crée une orientation préférentielle du spin des électrons du matériau optique.

Un dispositif de l'art connu, décrit dans le document EP-A1 n° 0 023 180 concerne un dispositif de mesure de courant comportant une fibre optique enroulée autour d'un conducteur dans lequel circule le courant I à mesurer, cette fibre optique comportant une ou plusieurs spires, les deux extrémités de cette fibre optique enroulée recevant chacune une onde optique issue par exemple d'un laser ; ces deux ondes circulent en sens contraires dans la fibre. Le courant circulant dans le conducteur induit un champ magnétique dans le même sens que le sens de propagation de l'une des ondes et en sens contraire de l'autre. Les deux ondes émergeant de la fibre présentent un déphasage $\Delta \Phi$ qui dépend de la constante de Verdet caractéristique de l'effet Faraday du milieu de propagation, de l'intensité I du courant circulant dans le conducteur, éventuellement du nombre N de conducteurs lorsque la fibre optique entoure plusieurs branches de conducteur dans lequel circule le même courant I, et du nombre M de tours de la fibre optique entourant le conducteur.

Pour mettre en évidence le déphasage entre les deux ondes, ce dispositif de mesure met en œuvre une structure d'interféromètre de type « Sagnac », les deux ondes contrarotatives émergeant des extrémités de la fibre étant recombinées et le signal correspondant étant détecté par un photodétecteur. Ainsi ces deux ondes subissent de la même manière les effets réciproques induisant dans le milieu des variations, dans les conditions de propagation, variant dans le même sens, et subissent par effet Faraday non réciproque des variations en sens contraire. Ces variations en sens contraire sont susceptibles d'être détectées par une méthode interférométrique.

L'article « system design considerations for precision measurement of high magnetic fields by Faraday effect » de M.A. Machado GAMA publié dans Optical an Quantum Electronics, vol. 7 de novembre 1975, décrit un dispositif dans lequel on prévoit un miroir orienté perpendiculairement à la direction d'un faisceau issu d'un milieu de propagation dans lequel le faisceau subit une rotation de polarisation. La réflexion du faisceau et son renvoi dans le milieu de propagation permet une rotation supplémentaire du plan de polarisation. On en déduit que l'on double l'effet Faraday. Cet article envisage donc d'augmenter la rotation du plan de polarisation par effet Faraday. Cependant, cet article ne fait pas état d'un milieu de propagation ayant ses modes propres de propagation polarisés droit et gauche permettant de conserver la polarisation circulaire. Il ne fournit aucun moyen pour éliminer l'action des effets réciproques.

L'article « Magneto-optic current sensing with birefringent fibers » de S.C. RASHLEIGH publié dans Applied Physics Letters, volume 34, du 1er juin 1979 mentionne l'utilisation d'une fibre à biréfringence circulaire, cependant le dispositif décrit ne permet pas d'éliminer les biréfringences circulaires réciproques.

Enfin l'article « Optical Measurement of High Electric and Magnetic Fields » de J.E. THOMPSON et al, publiée dans IEEE Transaction on Instrumentation and Measurement, volume 25, numéro 1, de mars 1976, décrit un dispositif dans lequel une onde lumineuse polarisée linéairement étant considérée comme une résultante des composantes de polarisation circulaires droite et gauche, un champ magnétique provoque un déphasage en sens contraire de ces composantes circulaires. Un dispositif de détection mesure alors le déphasage introduit entre les deux composantes circulaires droite et gauche.

Par rapport à ces dispositifs de l'art connu, le dispositif de l'invention présente différents avantages tels que sa grande simplicité, son petit nombre de composants. De plus, aucun alignement n'est nécessaire, si ce n'est celui de la source et de la fibre, ce qui fait partie de l'art connu. Ce dispositif a en outre une grande souplesse géométrique en ce qui concerne notamment la longueur de guide d'onde et en ce qui concerne la disposition géométrique donnée à ce guide d'onde.

Dans le dispositif de l'invention, seules des perturbations « non réciproques » ont un effet sur le signal détecté. Les variations dimensionnelles telles que fluage, dilatation thermique, variation de pression, où les variations d'indice de réfraction n'ont, elles, aucun effet sur le signal détecté. On dispose donc, en principe, d'un instrument de mesure des effets « non réciproques » qui présente une stabilité parfaite.

En pratique, pour que les perturbations réciproques aient un effet rigoureusement nul, il faut que les deux faisceaux du dispositif parcourent exactement le même trajet. Plus précisemment, il faut que les deux ondes soient deux solutions identiques de l'équation d'onde du dispositif, le signe du paramètre « temps » étant inversé.

Lorsque l'interféromètre est réalisé en propagation libre, et c'est le cas de l'utilisation d'éléments optiques discrets, cette condition n'est jamais strictement respectée :

— l'équation d'onde présente un « continuum » de solutions et le moindre désalignement des optiques conduit à l'obtention de solutions différentes, donc de fronts d'ondes non superposés ;

— même pour des solutions identiques lorsque des ondes d'extension infinie sont considérées, ondes planes par exemple, la distribution d'intensité, forcément limitée en pratique, diffère, en fait, ne serait-ce qu'à cause de la diffraction, et rompt la réciprocité.

Une solution de type monomode consiste donc en un dispositif réalisé en structure guide d'onde de bout en bout.

L'invention a pour objet un dispositif de mesure de champ magnétique de direction déterminée comportant une source délivrant un faisceau de lumière polarisée et parallèle à la direction du champ magnétique, un milieu de propagation magnétooptique positionné sur le trajet de ce faisceau et dans lequel les composantes de la lumière sont soumises au moins à un décalage de phase non réciproque par effet Faraday, le dispositif étant sensible uniquement audit décalage de phase non réciproque, un élément séparateur de lumière disposé entre cette source et ce milieu, un dispositif de détection couplé à cet élément séparateur de lumière, caractérisé en ce que : le faisceau de lumière est polarisé rectilignement ; le milieu de propagation magnétooptique présente une biréfringence circulaire, c'est-à-dire ayant des modes propres de propagation polarisés droit et gauche et conservant la polarisation circulaire ; le dispositif comprend également un miroir disposé perpendiculairement à la direction de propagation, sur le trajet du faisceau de lumière du côté opposé à la source par rapport au milieu de propagation de façon à inverser les rôles des modes de propagation polarisés droit et gauche et ainsi éliminer l'action des effets réciproques ; l'élément séparateur est un séparateur de polarisation permettant d'envoyer, au dispositif de détection, une partie du faisceau réfléchi par le miroir uniquement dans le cas où ce faisceau a subi ledit décalage de phase non réciproque.

L'invention a également pour objet un capteur de courant électrique comportant un tel dispositif.

L'invention sera mieux comprise et d'autres caractéristiques apparaîtront à l'aide de la description qui suit en référence aux figures annexées :

— la figure 1 représente le dispositif de l'invention ;

— les figures 2 et 3 représentent deux aspects particuliers du dispositif de l'invention.

De la même manière que dans le cas de propagation libre dans un milieu matériel, la composante du champ magnétique, colinéaire à la direction de propagation de la lumière dans une fibre optique induit une activité optique non réciproque proportionnelle à l'intensité du champ magnétique et à la constante de Verdet du matériau.

Cette activité optique non réciproque, trouve son origine dans l'action du champ magnétique sur l'orientation du spin des électrons. Cette action se traduit par une décomposition des raies spectrales en plusieurs composantes symétriques par rapport à la raie originale (effet Zeeman). Si l'observation est faite dans la direction du champ magnétique, on observe deux composantes polarisées circulairement dont l'espacement est proportionnel à l'intensité du champ magnétique, la raie de plus grande longueur d'onde ayant en général une polarisation circulaire de sens inverse au sens du courant créant le champ magnétique. La courbe de dispersion initiale est donc remplacée par deux courbes décalés, l'une correspondant aux vibrations circulaires droites, l'autre aux vibrations circulaires gauches. Aux longueurs d'ondes d'utilisation, en général très supérieures à la longueur d'onde de la bande d'absorption, apparaît donc une biréfringence circulaire proportionnelle à l'intensité du champ magnétique et liée à son orientation et à celle de la propagation lumineuse, donc non réciproque. Cet effet Faraday dépend du matériau considéré (constante de Verdet). S'il est très faible pour les matériaux diamagnétiques, il va en augmentant successivement pour les matériaux paramagnétiques puis ferromagnétiques. Il est important de noter que seulement pour les matériaux diamagnétiques, la constante de Verdet est indépendante de la température. La silice, matériau dont sont constituées les fibres optiques à faible atténuation, faisant partie de cette classe, un capteur ampèremétrique réalisé à partir de telle fibres bénéficie de cette propriété intéressante pour l'utilisateur.

Dans le cas de la propagation libre dans un milieu passif et dans le cas de la propagation guidée dans une fibre optique monomode idéale, c'est à dire dans laquelle les deux modes de polarisation polarisés quasi linéairement, de répartitions d'intensité identiques et de polarisations orthogonales (solution $HE_{11}$) sont parfaitement dégénérés, en l'absence de champ magnétique, les polarisations droite et gauche voient le même indice de réfraction. Ce n'est plus le cas en présence d'un champ magnétique, où les polarisations droite et gauche voient un indice différent. Il en résulte qu'une polarisation linéaire incidente tourne d'un angle $\Delta\Phi$ proportionnel au champ magnétique H.

Il importe de différentier les propriétés de la biréfringence circulaire magnétique (effet Faraday) de celles de la biréfringence circulaire naturelle (pouvoir rotatoire naturel ou activité optique).

L'effet Faraday dépend du sens de propagation de la lumière et est non réciproque, alors que le pouvoir rotatoire naturel est indépendant du sens de propagation de la lumière et est réciproque (un matériau est dextrogyre ou lévogyre indépendamment du sens de propagation de la lumière). Il s'ensuit que si l'on renvoie la lumière à travers le matériau après une réflexion sur un miroir, la rotation est doublée dans le premier cas, alors qu'elle est annulée dans le second.

La fibre optique est sensible aux variations de l'environnement qui peuvent en particulier induire une activité optique (principalement du fait des interactions élasto-optiques dans les phénomènes de torsion) susceptible d'évoluer dans le temps et qui pourrait naturellement être perçue comme une biréfringence circulaire magnétique dans une méthode de mesure basée sur la détermination de l'angle $\Delta\Phi$ après une seule traversée de la fibre optique.

Afin de pallier cet inconvénient, il importe d'utiliser une configuration du dispositif expérimental qui soit insensible aux effet réciproques perturbateurs. La configuration de l'invention est particulièrement bien adaptée.

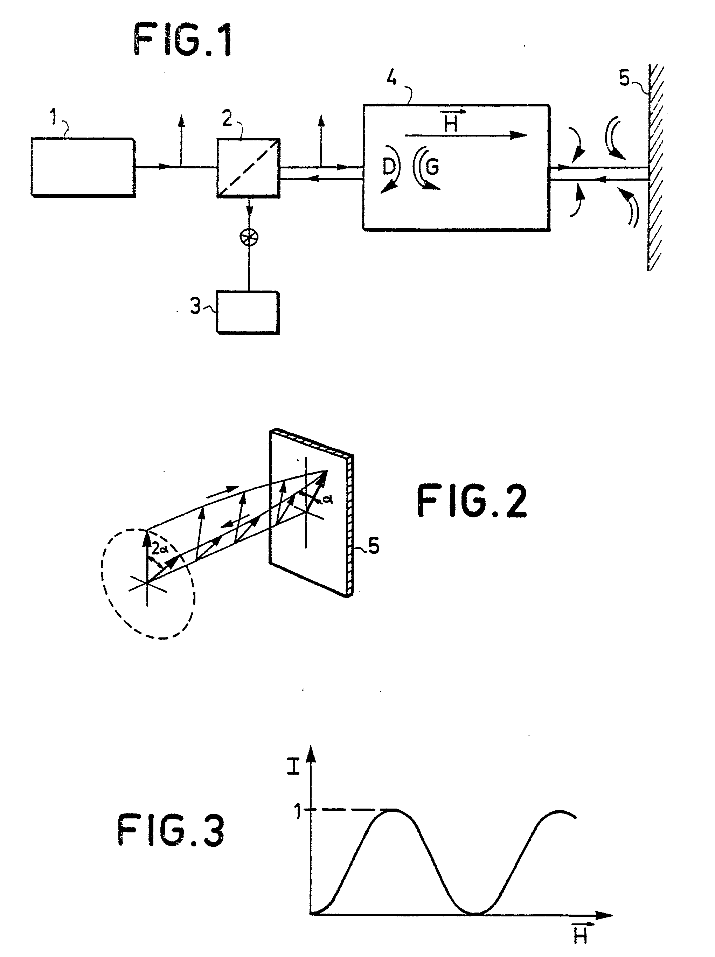

L'invention proposée ici représentée à la figure 1, met à profit l'utilisation de l'effet magnétique dans un milieu guidant 4 tel qu'une fibre optique monomode par exemple.

Cet effet correspond à un déphasage non réciproque entre deux ondes polarisées circulairement (l'une droite et l'autre gauche) sous l'action de la composante du champ magnétique parallèle à la direction de propagation. Ce déphasage peut s'exprimer sous la forme :

$$\Delta\Phi = A V H L$$

où V est la constante de Verdet du matériau, H le champ magnétique appliqué parallèlement à l'axe de la fibre et L la longueur d'interaction. A est une constante dépendant en particulier de la longueur d'onde utilisée.

Pour mettre en évidence le déphasage entre les deux ondes émergeant du milieu 4, elles sont recombinées et le signal correspondant est détecté par un photodétecteur 3.

Si une onde lumineuse se propage dans le milieu 4, le champ magnétique induit, par effet magnétooptique, des variations dans les conditions de propagation de l'onde lumineuse. Lorsque le champ magnétique et la direction de propagation de l'onde lumineuse sont parallèles, l'effet magnétooptique induit sur l'onde lumineuse est un effet non réciproque, effet Faraday, dépendant du sens de propagation de l'onde par rapport au sens du champ magnétique.

Pour mettre en évidence par cet effet non réciproque une quantité mesurable qui soit directement liée au champ magnétique, et qui par conséquent n'intègre pas d'autres effets et en particulier les effets réciproques produisant eux aussi des variations dans les conditions de propagation, (variation de température ou variation de pression par exemple), le dispositif suivant l'invention utilise deux ondes.

Ces deux ondes subissent de la même manière les effets réciproques induisant dans le milieu des variations dans les conditions de propagation variant dans le même sens, et subissent par effet Faraday non réciproque des variations en sens contraires. Ces variations en sens contraires sont susceptibles d'être détectées par une méthode interférométrique.

En effet la lumière polarisée linéairement issue du laser 1 après avoir traversé le prisme séparateur de polarisation 2 atteint le milieu magnétooptique 4 dont les modes propres de propagation sont polarisés droit et gauche. Ces deux ondes polarisées circulairement droit et gauche atteignent le miroir 5. L'onde polarisée circulairement à droite après réflexion sur ce miroir devient polarisée circulairement à gauche, et réciproquement l'onde polarisée circulairement à gauche devient polarisée circulairement à droite comme représenté à la figure 2.

Ainsi ce miroir 5 entraîne un changement de direction et un changement de polarisation circulaire des ondes qui l'atteignent.

Ce milieu 4 est réalisé avec n'importe quel matériau montrant de l'effet Faraday, cet effet étant d'autant plus fort que le matériau est plus magnétique. Avec un matériau ferromagnétique cet effet est plus important qu'avec un matériau diamagnétique, mais dans ce dernier cas, cet effet ne dépend pas de la température.

Les ondes lumineuses de polarisations circulaires gauche et droite se propageant dans le milieu 4 subissent un déphasage induit par effet Faraday par le champ magnétique. Le milieu magnétooptique induit sur les ondes lumineuses qui se propagent des variations de polarisation. Ces effets sont réciproques et agissent sur les deux ondes de la même manière ; par contre l'effet de polarisation magnétique agissant seulement sur les ondes de polarisation circulaire pour introduire une avance ou un retard sur chacune des composantes, agit dans des sens différents sur les deux ondes et introduit donc entre elles un déphasage global. En effet pour ces ondes l'établissement du champ magnétique parallèle à la direction de propagation avance la vibration circulaire dans le même sens que le courant magnétisant et retarde d'une quantité égale la vibration circulaire en sens contraire. Même si l'état de polarisation de l'onde lumineuse varie au cours de sa propagation le long de la fibre, les effets d'avance et de retard se cumulent le long de cette fibre et les deux ondes émergentes présentent un déphasage susceptible d'être détecté et représentant directement les effets induits par le champ magnétique, les autres effets étant subis de manière identique par les deux ondes et n'introduisant donc pas entre elles de déphasage.

Le dispositif de mesure représenté fournit sur le détecteur une intensité lumineuse I qui varie en fonction du déphasage entre les deux ondes et donc du champ magnétique, comme représenté sur la courbe à la figure 3.

Si on considère le schéma de principe de la figure 1. La lumière polarisée linéairement issue d'un laser 1 traverse tout d'abord un prisme séparateur de polarisation 2. Elle passe ensuite à travers le milieu magnétooptique 4 dont on supposera que les modes propres de propagation sont polarisés droit et gauche. Après traversée de ce milieu 4, ces ondes sont réfléchies sur un miroir 5 et repassent dans le milieu 4 pour être analysées par 2. La détection est assurée par un photodétecteur 3.

Les ondes traversant le milieu 4 de gauche à droite ont des phases à la sortie :

$\Phi_D \propto n_D L$ (onde polarisée droite)
$\Phi_G \propto n_G L$ (onde polarisée gauche)

Dans ces formules :

$\Phi_D$ est la phase de l'onde polarisée droite à la sortie ;
$\Phi_G$ est la phase de l'onde polarisée gauche à la sortie ;
$\propto$ signifiant : « proportionnel à »
$n_D$ est l'indice de réfraction du milieu 4, pour l'onde polarisée droite ;
$n_G$ est l'indice de réfraction du milieu 4, pour l'onde polarisée gauche.
L est la longueur du milieu.

Si on applique un champ magnétique H : on induit des déphasages $\Delta\Phi_H$ et $-\Delta\Phi_H$

$\Phi_D \propto n_D L + \Delta\Phi_H$
$\Phi_G \propto n_G L - \Delta\Phi_H$

Comme représenté à la figure 2, à la reflexion sur le miroir 5, l'onde droite devient gauche. De même l'onde gauche devient droite. Le sens relatif du champ et de la direction de propagation ayant été renversé, ces ondes émergent de nouveau du milieu 4 avec des phases :

$\Phi_{DG} \propto n_D L + n_G L + \Delta\Phi_H + \Delta\Phi_H$
$\Phi_{GD} \propto n_G L + n_D L - \Delta\Phi_H - \Delta\Phi_H$

d'où

$\Delta\Phi = \Phi_{DG} - \Phi_{GD} = 4 \Delta\Phi_H$

et les déphasages dus à la biréfringence naturelle du milieu et à des variations réciproques ont disparu.

Ce déphasage $\Delta\Phi$ induit une apparition de signal lumineux sur le photodétecteur 3 traduisant l'action du champ magnétique H.

Le senseur est donc sensible au champ magnétique et insensible aux paramètres réciproques du milieu.

L'élément 2 peut être un cube séparateur de polarisation constitué de deux prismes collés, la surface de séparation constituée par l'hypoténuse de ces deux prismes qui est semi-réfléchissante étant traitée de façon à être séparatrice de polarisation. Cet élément présente un axe optique préférentiel. Les rayons incidents ayant une direction de polarisation parallèle à cet axe sont transmis en totalité sans modification, parallèlement à la direction d'incidence. Les rayons incidents ayant une direction de polarisation orthogonale à la direction précédente sont réfléchis en totalité suivant une direction orthogonale à la direction d'incidence. Les faces du cube ont subi, en outre, un traitement de surface pour éviter les reflets parasites.

Cet élément 2 pourrait aussi être un circuit optique intégrée alimenté par la source 1 directement couplée par la tranche à la plaquette de circuit intégré, de la même façon que le milieu 4 et le détecteur 3.

Après reflexion sur le miroir les deux ondes de polarisations circulaires suivent le chemin optique inverse et sont toujours polarisées circulairement.

Mais le faisceau composite transmis au cube polariseur est à nouveau polarisé linéairement. En effet, comme cela vient d'être expliqué, à la sortie du milieu, au retour des deux ondes, les déphasages dus à la biréfringence naturelle du milieu et à des variations réciproques ont disparu.

Dans le milieu 4 le pouvoir rotatoire va se compenser entre l'aller et le retour, contrairement à l'effet Faraday qui va se cumuler.

Ainsi sans champ magnétique et donc sans effet Faraday on obtient au retour sur le séparateur de polarisation une même polarisation linéaire qu'à l'aller, et l'onde résultante est donc dirigé vers la source.

Par contre, s'il existe un champ magnétique colinéaire avec la direction de l'onde lumineuse, la projection de l'onde linéaire résultante sur la direction à $\pi/2$ n'est plus nulle, et une partie de l'onde lumineuse dépendant du champ magnétique va atteindre le détecteur, en effet à la traversée du cube séparateur par polarisation elle va être réfléchie par la face commune du cube.

Pour réaliser le milieu 4, on peut considérer une fibre optique ayant peu ou pas de biréfringence linéaire. Cette fibre peut être réalisée en un matériau ayant un effet Faraday plus prononcé tel que le grenat de fer et d'Itrium (Yig). Elle peut aussi être réalisée en silice pour laquelle l'effet Faraday est faible mais indépendant de la température.

Les fibres monomodes fabriquées habituellement pour les télécommunications présentent toujours une petite quantité biréfringence linéaire, et de biréfringence circulaire. Par suite ces fibres ne concervent ni la polarisation linéaire, ni la polarisation circulaire.

Il est possible de considérer une méthode qui consiste à introduire une biréfringence circulaire ou pouvoir rotatoire élevée de façon à conserver la polarisation circulaire.

Une solution pour créer cette polarisation circulaire consiste à soumettre la fibre de verre à contrainte statique de torsion, par exemple appliquée extérieurement par torsion entre ses deux extrémités : un effet de la torsion de cette fibre est d'introduire une biréfringence circulaire dans celle-ci. Divers procédés de l'art connu permettent alors de conserver cet état de torsion. Ce peut être, notamment, à l'aide d'une frette mécanique.

Le senseur peut être réalisé avantageusement à l'aide d'une fibre monomode conservant la polarisation circulaire dont l'extrémité a été métallisée (ou traitée) de façon à être totalement réfléchissante. Le laser utilisé peut être un laser semiconducteur. La fibre optique conservant la polarisation circulaire peut être réalisée en torsadant une fibre monomode avec un taux de l'ordre de quelques dizaines de tours par mètre. Cette fibre peut être, soit laissée droite, soit enroulée autour d'un conducteur pour réaliser un senseur de courant.

Il est bien évident que toute méthode classique de modulation de phase permettant de travailler autour d'un zéro décrite pour d'autres capteurs de l'art connu est applicable pour ce dispositif de l'invention.

On peut utiliser ce dispositif de l'invention pour réaliser un capteur de courant en réalisant une boucle d'une ou de plusieurs spires à l'aide de cette fibre autour du conducteur dans lequel ce courant circule. En effet pour chaque onde l'établissement du champ magnétique parallèle à la direction de propagation avance la vibration circulaire dans le même sens que le courant magnétisant et retarde d'une quantité égale la vibration circulaire en sens contraire. Même si l'état de polarisation de l'onde lumineuse varie au cours de sa propagation le long de la fibre, les effets d'avance et de retard se cumulent le long de cette fibre et les deux ondes émergentes présentent un déphasage susceptible d'être détecté et représentant directement les effets induits par le courant I circulant dans le conducteur, les autres effets étant subis de manière identique par les deux ondes et n'introduisant donc pas entre elles de déphasage.

## Revendications

1. Dispositif de mesure de champ magnétique de direction déterminée comportant une source (1) délivrant un faisceau de lumière polarisée et parallèle à la direction du champ magnétique, un milieu de propagation (4) magnétooptique positionné sur le trajet de ce faisceau et dans lequel les composantes de la lumière sont soumises au moins à un décalage de phase non réciproque par effet Faraday, le dispositif étant sensible uniquement audit décalage de phase non réciproque, un élément séparateur de lumière (2) disposé entre cette source (1) et ce milieu (4), un dispositif de détection (3) couplé à cet élément séparateur de lumière (2), caractérisé en ce que : le faisceau de lumière est polarisée rectilignement ; le milieu de propagation (4) magnétooptique présente une bérifringence circulaire, c'est-à-dire ayant des modes propres de propagation polarisés droit et gauche et conservant la polarisation circulaire ; le dispositif comprend également un miroir (5) disposé perpendiculairement à la direction de propagation, sur le trajet du faisceau de lumière du côté opposé à la source par rapport au milieu de propagation de façon à inverser les rôles des modes de propagation polarisés droit et gauche et ainsi éliminer l'action des effets réciproques ; l'élément séparateur (2) est un séparateur de polarisation permettant d'envoyer, au dispositif de détection (3), une partie du faisceau réfléchi par le miroir uniquement dans le cas où ce faisceau a subi ledit décalage de phase non réciproque.

2. Dispositif suivant la revendication 1, caractérisé en ce que la source (1) est un laser semiconducteur.

3. Dispositif suivant la revendication 1, caractérisé en ce que l'élément séparateur par polarisation (2) comporte deux prismes réfringents accolés par leur hypothénuses de façon à former une surface séparatrice semi-réfléchissante.

4. Dispositif suivant la revendication 1, caractérisé en ce que l'élément séparateur par polarisation est un élément optique intégré.

5. Dispositif suivant la revendication 1, caractérisé en ce que le milieu de propagation (4) conservant la polarisation circulaire est une fibre monomode.

6. Dispositif suivant la revendication 5, caractérisé en ce que la fibre est torsadée.

7. Dispositif suivant la revendication 5, caractérisé en ce que la fibre est en silice.

8. Dispositif suivant la revendication 5, caractérisé en ce que la fibre est en grenat de fer et d'Itrium.

9. Dispositif suivant la revendication 5, caractérisé en ce que l'extrémité de la fibre est métallisée.

10. Dispositif suivant la revendication 1, caractérisé en ce que la source (1) est un laser impulsionnel.

11. Capteur de courant électrique à effet Faraday, caractérisé en ce qu'il comporte un dispositif selon l'une quelconque des revendications 1 à 10, le milieu de propagation formant au moins une boucle autour d'un conducteur dans lequel ce courant circule.

## Claims

1. A device for measuring the magnetic field of a predetermined direction, comprising a source (1) which supplies a beam of polarized light parrallel to the direction of the magnetic field, a magneto-optical propagation medium (4) located in the beam trajectory and submitting the light components at least to a non-reciprocal phase-shift due to the Faraday effect, the device being sensitive only to non-reciprocal phase-shifts, further comprising a light separator element (2) disposed between said source (1) and said medium (4), and a detection device (3) coupled to this light separator element (2), characterized in that the light beam is linearly polarized, that the magneto-optical propagation medium (4) presents a circular birefraction, that means it has right-hand and left-hand polarized intrinsec propagation modes and conserves the circular polarisation, that the device further comprises a mirror (5) disposed perpendicularly to the propagation direction in the beam trojectory on that side of the propagation medium which is remote from the source such that it inverts the roles of the left-hand and right-hand polarized propagation modes and that the action of the reciprocal effects are eliminated, and that the separator element (2) is a polarisation separator allowing to only transmit to the detection device (3) a fraction of the beam reflected by the mirror if this beam has been submitted to said non-reciprocal phase-shift.

2. A device according to claim 1, characterized in that the source (1) is a semiconductor laser.

3. A device according to claim 1, characterized in that the polarisation separator element (2) comprises two refracting prisms which are joint together along their hypotenuses in order to constitute a semi-reflecting separator surface.

4. A device according to claim 1, characterized in that the polarisation separator element is an integrated optical element.

5. A device according to claim 1, characterized in that the propagation medium (4) conserving the circular polarisation is a monomode fibre.

6. A device according to claim 5, characterized in that the fibre is twisted.

7. A device according to claim 5, characterized in that the fibre is made of silicon dioxide.

8. A device according to claim 5, characterized in that the fibre is made of iron and yttrium garnet.

9. A device according to claim 5, characterized in that the end of the fibre is metal coated.

10. A device according to claim 1, characterized in that the source (1) is a pulsed laser.

11. A probe for measuring electric currents according to the Faraday effect, characterized in that it comprises a device according to anyone of claims 1 to 10, the propagation medium constituting at least a loop about a conductor in which this current flows.

**Patentansprüche**

1. Vorrichtung zur Messung eines Magnetfelds einer bestimmten Richtung, mit einer Strahlquelle (1), die einen Strahl polarisierten und zur Richtung des Magnetfelds parallelen Lichts liefert, mit einem magneto-optischen Ausbreitungsmedium (4), das sich im Strahlverlauf befindet und in dem die Komponenten des Lichts mindestens einer nichtreziproken Phasenverschiebung durch Faraday-Effekt unterliegen, wobei die Vorrichtung nur auf die nicht-reziproke Phasenverschiebung anspricht, mit einer Lichttrennvorrichtung (2), die zwischen der Quelle (1) und diesem Medium (4) liegt, mit einer Detektorvorrichtung (3), die an die Lichttrennvorrichtung (2) gekoppelt ist, dadurch gekennzeichnet, daß der Lichtstrahl linear polarisiert ist, daß das magneto-optische Fortpflanzungsmedium (4) eine kreisförmige Doppelbrechung besitzt, d.h. rechts- und linksdrehend polarisierte Eigenfortpflanzungsmodi besitzt und die Kreispolarisation beibehält, daß die Vorrichtung weiter einen Spiegel (5) aufweist, der senkrecht zur Fortpflanzungsrichtung im Lichtstrahl jenseits des magneto-optischen Fortpflanzungsmediums liegt und die Rolle der links- und rechtsdrehend polarisierten Fortpflanzungsmodi umkehrt und so die Wirkung der reziproken Effekte beseitigt, daß das Trennelement (2) ein Polarisationsseparator ist, der es ermöglicht, nur dann einen Teil des am Spiegel reflektierten Strahls an die Detektorvorrichtung (3) zu senden, wenn der Strahl eine nichtreziproke Phasenverschiebung erfahren hat.

2. Vorrichtung nach Anspruch 1, dadurch gekennzeichnet, daß die Quelle (1) ein Halbleiterlaser ist.

3. Vorrichtung nach Anspruch 1, dadurch gekennzeichnet, daß das Polarisations-Separatorelement (2) zwei mit ihren Hypotenusen aneinandergeklebte Brechungsprismen enthält, sodaß sich eine halb-reflektierende Trennfläche ergibt.

4. Vorrichtung nach Anspruch 1, dadurch gekennzeichnet, daß das Polarisations-Separatorelement ein integriertes optisches Element ist.

5. Vorrichtung nach Anspruch 1, dadurch gekennzeichnet, daß das Fortpflanzungsmedium (4), das die kreisförmige Polarisation zu erhalten erlaubt, eine Monomode-Faser ist.

6. Vorrichtung nach Anspruch 5, dadurch gekennzeichnet, daß die Faser verdrillt ist.

7. Vorrichtung nach Anspruch 5, dadurch gekennzeichnet, daß die Faser aus Siliziumdioxid ist.

8. Vorrichtung nach Anspruch 5, dadurch gekennzeichnet, daß die Faser aus Eisen- und Yttriumgranat ist.

9. Vorrichtung nach Anspruch 5, dadurch gekennzeichnet, daß das Ende der Faser metallisiert ist.

10. Vorrichtung nach Anspruch 1, dadurch gekennzeichnet, daß die Quelle (1) ein Impulslaser ist.

11. Elektrische Stromsonde auf der Basis des Faraday-Effekts, dadurch gekennzeichnet, daß sie eine Vorrichtung nach einem der Ansprüche 1 bis 10 enthält, wobei das Fortpflanzungsmedium mindestens eins Schleife um einen Leiter bildet, in dem der Strom fließt.

# FIG.1

# FIG.2

# FIG.3